# EUROPEAN PATENT SPECIFICATION

(11) **EP 1 691 485 B1**
(45) Date of publication and mention of the grant of the patent: **10.10.2007**
(21) Application number: 06250546.6
(22) Date of filing: 01.02.2006
(51) Int. Cl.: H03K 17/22, H04N 5/00

(54) **Electronic device comprising audio mute control circuit**
Elektronische Vorrichtung enhaltend eine Steuerschaltung zum Audiostumm
Dispositif électronique comprenant un circuit de contrôle de sourdine

(30) Priority: 10.02.2005 JP 2005034576
(43) Date of publication of application: 16.08.2006
(73) Proprietor: ORION ELECTRIC CO., Ltd., Fukui 915-8555 (JP)
(72) Inventor: Takei, Yusuke c/o Intellectual Property Dept.,, Echizen-city, Fukui 915-8555 (JP)
(74) Representative: Paget, Hugh Charles Edward

(56) References cited:
- PATENT ABSTRACTS OF JAPAN vol. 1997, no. 02, 28 February 1997 (1997-02-28) -& JP 08 279740 A (NIPPON COLUMBIA CO LTD), 22 October 1996 (1996-10-22)
- PATENT ABSTRACTS OF JAPAN vol. 2003, no. 04, 2 April 2003 (2003-04-02) -& JP 2002 354571 A (LG ELECTRONICS INC), 6 December 2002 (2002-12-06)

## Description

### BACKGROUND OF THE INVENTION

### Field of the Invention

The present invention relates to an electronic device comprising an audio processing circuit for processing an audio signal and particularly relates to an electronic device comprising an audio mute control circuit for preventing the output of a signal acting as noise (click noise) from an audio processing circuit.

### Description of the Related Art

Conventionally, when the power switch of a device is turned on/off in an electronic device having an audio output function, audio output is muted to prevent the output of a "click noise" which is caused by noise generated in transition to and from start-up or shutdown of a power supply. Conventional techniques for preventing such a "click noise" are disclosed in Japanese Patent Laid-Open Publication No. 9-102751, Japanese Patent Laid-Open Publication No. 2001-267943 and Japanese Patent Laid-Open Publication No. 2003-204591 (Patent Documents 1 to 3) and so on.

"Power supply shutdown" in which the power supply of an electronic device is shifted from an on state to an off state is generally caused by the input of a power switch provided on the device (a main power switch provided on a device or a power switch provided on a remote control) . "Power supply shutdown" may occur without the input of a power switch, for example, when a device is unplugged. In recent years, in order to save "standby power consumption" of electronic devices, "power strips" with switches for turning on/off supply of power have been widely used. When the switch of a power strip is turned off in a state in which the power supply of an electronic device is turned on, the electronic device has the same state as the unplugged device. The probability of the occurrence of such a case ("power supply shutdown" not caused by the input of a power switch) has been increased.

The conventional techniques disclosed in the patent documents are devised to prevent a "click sound" from being outputted when the power switch of a device is turned on/off. A state of the power switch of a device is monitored and decided by a microcomputer or the like and audio output is muted according to the state of the power switch. Thus, audio output may not be muted in the case of "power supply shutdown" not caused by the input of the power switch (when power supply from an external power supply is suspended), or a "click noise" may occur when muting is late (power shutdown noise occurs before a mute signal is outputted through processing in a microcomputer or the like).

JP-A-08-279740 describes audio equipment having an audio processing circuit and a muting circuit. The muting circuit is controlled by a microcomputer. The device includes detection means to detect the length of the time of interruption of power source. This circuit provides an output signal to the microcomputer, in dependence on the detected length of the time of interruption of service. The aim is to avoid a long muting period, when there is a short interruption of the power source.

### SUMMARY OF THE INVENTION

In view of the above-described points, the present invention has as its object the provision of an electronic device comprising an audio mute control circuit for preventing the occurrence of a "click sound" even in "power supply shutdown" not caused by the input of a power switch.

An electronic device comprises an audio mute control circuit according to claim 1.

With this configuration, the power fail signal outputted from the power failure detection circuit capable of detecting the suspension of power supply from the external power supply ("power supply shutdown" not caused by the input of a power switch) is used as the mute control signal of the audio processing circuit.

An electronic device comprises an audio mute control circuit according to claim 2.

With this configuration, when the power failure detection circuit detects the suspension of power supply from the external power supply, the audio processing circuit is muted by the power fail signal outputted from the power failure detection circuit. In the presence of power supply, the muting operation of the audio processing circuit is controlled by the mute control signal from the microcomputer.

An electronic device comprises an audio mute control circuit according to claim 3.

With this configuration, when the power failure detection circuit detects the suspension of power supply from the external power supply, the first transistor is turned off in response to the power fail signal outputted from the power failure detection circuit, so that the third transistor is also turned off. Thus, the output of the constant voltage source is directly inputted to the audio mute control circuit and acts as a mute command. Therefore, the control of the microcomputer or the like or an element controlled by the microcomputer or the like is not present between "the detection of the suspension of power supply from the external power supply" and "the output of the mute command to the audio mute control circuit."

An electronic device comprises an audio mute control circuit according to claim 4.

With this configuration, the "audio mute control circuit" can be configured with two transistors.

### BRIEF DESCRIPTION OF THE DRAWINGS

FIG. 1 is a block diagram schematically showing only a part of a liquid crystal display according to the present invention.
FIG. 2 is a perspective view showing the liquid crystal display.
FIG. 3 is a circuit diagram showing an example of an audio mute control circuit.
FIG. 4 is a circuit diagram schematically showing an audio mute control circuit of Embodiment 2.
FIG. 5 is a block diagram showing an example of a conventional device.

### DETAILED DESCRIPTION OF THE PREFERRED EMBODIMENTS

Specific embodiments of the present invention will be described below in accordance with the accompanying drawings. The following embodiments are just concrete forms of the present invention and thus the present invention is not limited within the embodiments.

### [Embodiment 1]

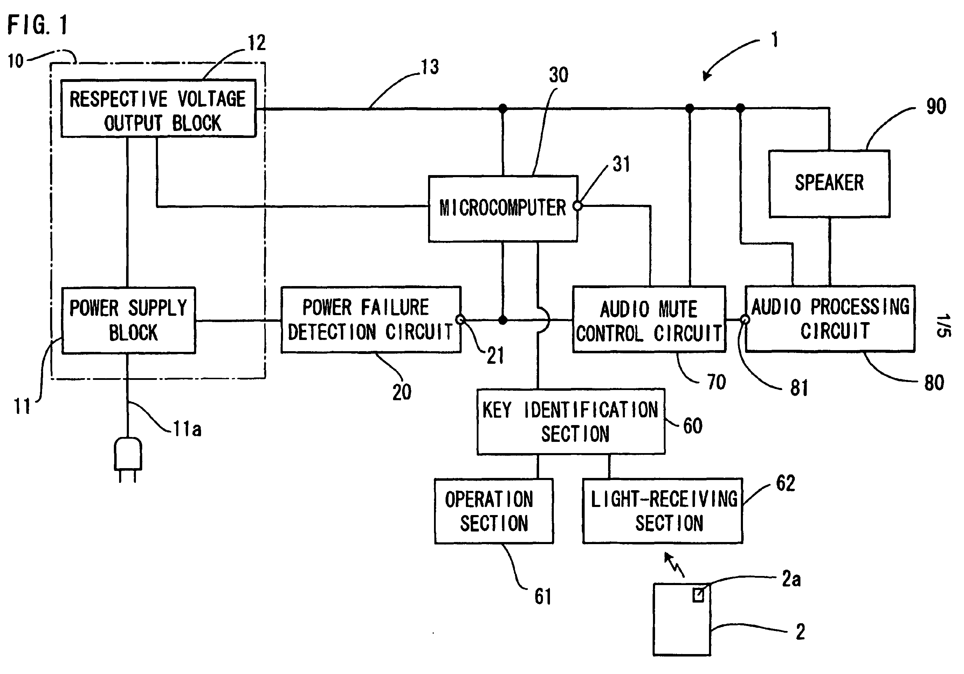

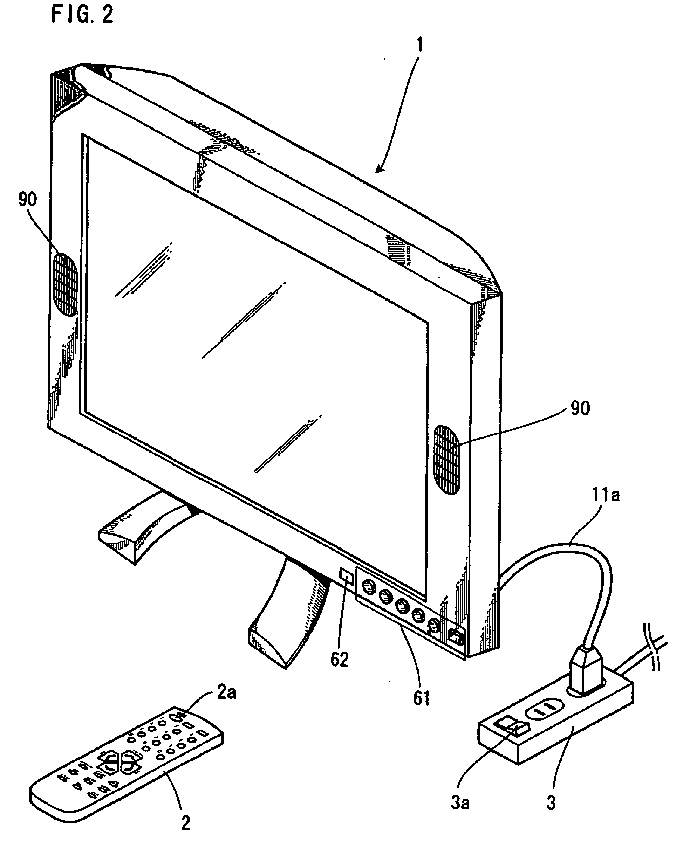

FIG. 1 is a block diagram schematically showing only a part of a liquid crystal display of the present embodiment according to the present invention. FIG. 2 is a perspective view showing the liquid crystal display.

As shown in FIG. 1, a liquid crystal display (hereinafter, simply referred to as an LCD) 1 of the present embodiment comprises a power supply unit 10 which is fed with power from a commercial power supply (external power supply) through a power cord 11a and supplies the power to the overall device, a power failure detection circuit 20 which detects the presence or absence of power supply from the commercial power supply to the power supply unit 10 and outputs the detection result as a power fail signal, a microcomputer 30 for controlling the overall device, a key identification section 60 which identifies a signal from an operation section 61 or a light-receiving section 62 and outputs the signal, an audio mute control circuit 70 which performs a switching operation in response to a mute control signal from the microcomputer 30 and the power fail signal outputted from the power failure detection circuit 20, an audio processing circuit 80 for processing an audio signal, and a speaker 90 which outputs audio in response to a signal from the audio processing circuit 80.

A respective voltage output block 12 provided in the power supply unit 10 supplies corresponding voltages to the respective parts of the device (so-called secondary power supply in FIG. 1 which shows, for simplicity, that power is fed to each part through a single power supply line 13, though power supply lines are provided for the respective voltages in an actual configuration) and the on/off of power supply is controlled by the microcomputer 30 (for example, power supply to an unnecessary part is shut off during standby). The power failure detection circuit 20 detects the presence or absence of power supply from the commercial power supply to the power supply unit 10. In the present embodiment, the power failure detection circuit 20 outputs, as a power fail signal, a high-level signal (DC voltage) in the presence of power supply from the commercial power supply, and outputs a low-level signal when power supply from the commercial power supply is suspended (for example, when power fails, the power cord 11a is removed, or a switch 3a of a power strip 3 (FIG. 2) connected to the power cord 11a is turned off). The audio mute control circuit 70 outputs a mute control signal for controlling the muting operation of the audio processing circuit 80, based on a mute control signal from the microcomputer 30 and the power fail signal outputted from the power failure detection circuit 20.

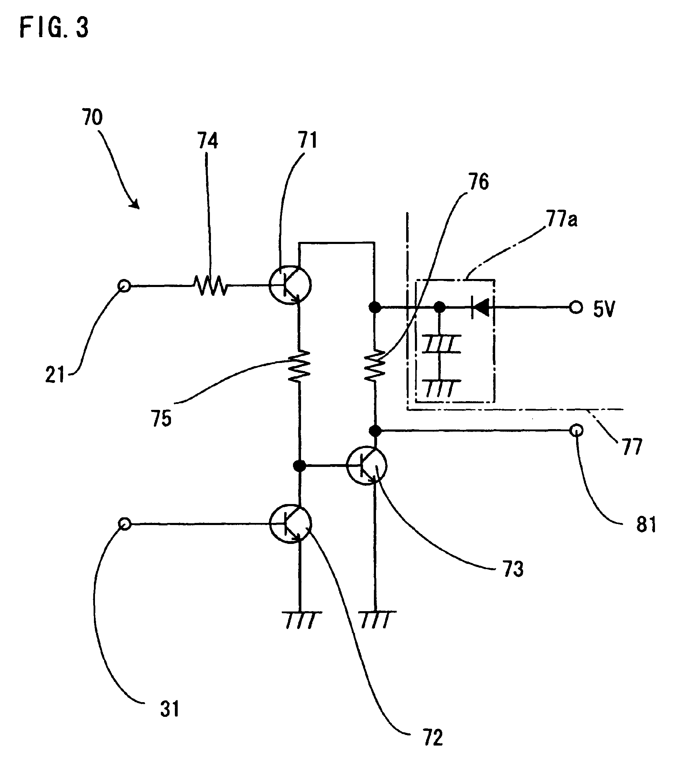

FIG. 3 shows an example of the circuit configuration of the audio mute control circuit 70. As shown in FIG. 3, the audio mute control circuit 70 is configured such that the base of a transistor 71 (first transistor) is connected to a power fail output terminal 21 via a resistor 74, the power fail output terminal 21 being provided on the power failure detection circuit 20 to output the power fail signal, a constant voltage source 77 is connected to the collector of the transistor 71 (the constant voltage source 77 is connected to a 5V power supply line via a rectifying/smoothing circuit 77a, and mainly acts, in the operation of the present invention, as a backup power supply in the absence of power supply from the external power supply, though referred to as a "constant voltage source," and the constant voltage source 77 inputs, after power supply is suspended, a "mute control signal" to a mute control input terminal 81 in response to discharge of charge built up on a capacitor provided in the rectifying/smoothing circuit 77a), the collector of a transistor 72 (second transistor) is connected to the emitter of the transistor 71 via a resistor 75, a mute control signal output terminal 31 is connected to the base of the transistor 72, the terminal 31 being provided on the microcomputer 30 to output the mute control signal, the emitter of the transistor 72 is connected to the ground, the collector of the transistor 72 and the base of a transistor 73 (third transistor) are connected to each other, the constant voltage source 77 is connected to the collector of the transistor 73 via a resistor 76, the emitter of the transistor 73 is connected to the ground, and the collector of the transistor 73 is connected to the mute control signal input terminal 81 which is provided on the audio processing circuit 80 and receives the input of the mute control signal.

The following is the outline of the operation of the audio mute control circuit 70 configured thus. When the power fail signal from the power fail output terminal 21 is at high-level (in other words, in the presence of power supply from the commercial power supply), the transistor 71 is turned on. Thus, the on/off of the transistor 73 is controlled by the mute control signal from the microcomputer 30. That is, when the mute control signal from the microcomputer 30 (mute control signal output terminal 31) is a high-level signal, since the transistor 72 is turned on, the base of the transistor 73 has a ground potential (precisely, higher than the ground potential by a voltage drop of the transistor 72) and the transistor 73 is turned off. On the other hand, when the mute control signal from the microcomputer 30 is a low-level signal, the transistor 72 is turned off and the voltage of the constant voltage source 77 is applied to the base of the transistor 73 after being adjusted by the resistor 75, so that the transistor 73 is turned on. In response to the on/off of the transistor 73, the voltage (high-level signal) of the constant voltage source 77 is inputted to the mute control signal input terminal 81 after being adjusted by the ground potential (low-level signal)/resistor 76. Thus, when the power fail signal is at high level, the muting operation of the audio processing circuit 80 is controlled by the mute control signal from the microcomputer 30.

In contrast, when the power fail signal from the power fail output terminal 21 is at low level (in other words, in the absence of power supply from the commercial power supply), the transistor 71 is turned off and the transistor 73 is also turned off accordingly. Thus, the voltage (high-level signal) of the constant voltage source 77 is inputted to the mute control signal input terminal 81 after being adjusted by the resistor 76. Therefore, when the power fail signal is at low level, regardless of the mute control signal from the microcomputer 30, the audio processing circuit 80 is immediately muted by the power fail signal from the power failure detection circuit 20.

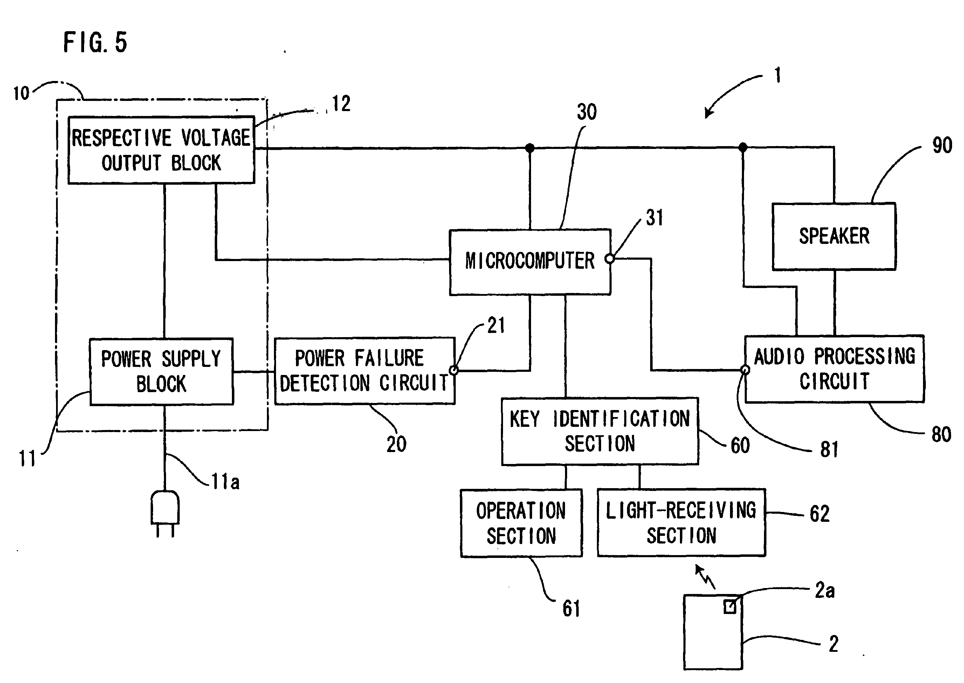

FIG. 5 is a block diagram schematically showing an example of a conventional device (the same constituent elements as the present embodiment are indicated by the same reference numerals) . In this device, for example, when the device is powered off by the input of a power switch 2a provided on a remote control unit 2, a microcomputer 30 obtains a "power-off command" through a key identification section 60, outputs a mute command to an audio processing circuit 80, and then "stops power supply" to a respective voltage output block 12. Thus, muting can be performed in the audio processing circuit 80 before "power supply shutdown, " thereby preventing the occurrence of a "click noise." However, when power supply from an external power supply is suspended, for example, due to the removal of a power cord 11a, decision and processing are performed in the microcomputer 30 in response to a signal from a power failure detection circuit 20 having detected the suspension of power supply, and a mute signal is outputted to the audio processing circuit 80. In the audio processing circuit 80, immediately after "power supply from the external power supply is suspended," "power supply shutdown" may occur (the timing of "power supply shutdown" varies with the designs of a power supply unit, and when a large-capacity capacitor or the like is provided on a power supply line to delay the timing of "power supply shutdown," the cost and the circuit space are increased). Thus, due to delay caused by processing time or the like in the microcomputer 30, muting is late and a "click noise" may occur from speakers 90. When the power failure detection circuit 20 is not provided and the voltage of a power supply output line (secondary power supply line) from the respective voltage output block 12 is monitored by the microcomputer 30, response is further delayed (a power supply line generally comprises a capacitor and the detection of "power supply suspension" is delayed by a time to discharge charge built up on the capacitor), so that muting is late and a "click noise" may occur from the speakers 90.

According to the present embodiment in contrast to the conventional device, as described above, the suspension of power supply from the external power supply is instantly detected by the power failure detection circuit and a mute command is outputted to the audio processing circuit 80 without passing through the processing of the microcomputer 30 or an element controlled by the microcomputer 30. Thus, it is possible to achieve a quick response and effectively prevent the occurrence of a "click noise."

### [Embodiment 2]

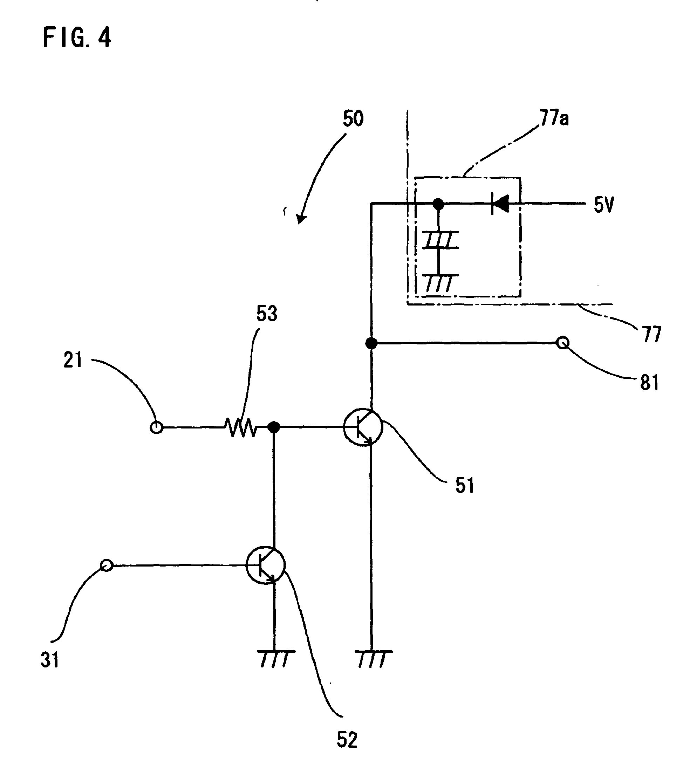

FIG. 4 is a circuit diagram schematically showing an audio mute control circuit of the present embodiment. A device comprising the audio mute control circuit is an LCD similar to that of Embodiment 1. The same constituent elements as Embodiment 1 are indicated by the same reference numerals and the explanation thereof is omitted.

As shown in FIG. 4, an audio mute control circuit 50 is configured such that the base of a transistor 51 (fourth transistor) is connected to a power fail output terminal 21 via a resistor 53, the power fail output terminal 21 being provided on a power failure detection circuit 20 to output a power fail signal, a constant voltage source 77 is connected to the collector of the transistor 51, the emitter of the transistor 51 is connected to the ground, the collector of a transistor 52 (fifth transistor) having its base connected to a mute control signal output terminal 31 is connected to the base of the transistor 51, the emitter of the transistor 52 is connected to the ground, and the collector of the transistor 51 is connected to a mute control signal input terminal 81.

The following is the outline of the operation of the audio mute control circuit 50 configured thus. When the power fail signal from the power fail output terminal 21 is at high level, the on/off of the transistor 51 is controlled by a mute control signal from a microcomputer 30 (the mute control signal output terminal 31). That is, when the mute control signal from the microcomputer 30 is a high-level signal, since the transistor 52 is turned on, the base of the transistor 51 has a ground potential and the transistor 51 is turned off. On the other hand, when the mute control signal from the microcomputer 30 is a low-level signal, the transistor 52 is turned off and a power fail signal (high level) is inputted to the base of the transistor 51, so that the transistor 51 is turned on. In response to the on/off of the transistor 51, the ground potential (low-level signal)/ the voltage (high-level signal) of a constant voltage source 77 are inputted to the mute control signal input terminal 81. Thus, when the power fail signal is at high level, the muting operation of an audio processing circuit 80 is controlled by the mute control signal from the microcomputer 30.

In contrast, when the power fail signal from the power fail output terminal 21 is at low level, the transistor 51 is turned off. Thus, the voltage (high-level signal) of the constant voltage source 77 is inputted to the mute control signal input terminal 81. Therefore, when the power fail signal is at low level, regardless of the mute control signal from the microcomputer 30, the audio processing circuit 80 is muted by the power fail signal from the power failure detection circuit 20.

As described above, according to the audio mute control circuit 50 of the present embodiment, the same operation as the audio mute control circuit 70 of Embodiment 1 is performed, thereby effectively preventing the occurrence of a "click noise." Additionally, the audio mute control circuit can be configured with two transistors, achieving an inexpensive and space-saving circuit configuration. Further, during an operation when the power fail signal is at low level, a control signal is inputted from the power failure detection circuit 20 to the audio processing circuit 80 only through a single transistor, thereby effectively preventing the occurrence of a "click noise" with higher responsiveness.

Resistors in the audio mute control circuit of the embodiment are mainly used for fine adjustments on voltage and the resistors are not always necessary for some qualities of voltage applied to each signal line (the design of each circuit connected to the audio mute control circuit). In these embodiments, an LCD was described as a specific example of an electronic device. The present invention is not limited to this example and is applicable to an electronic device comprising a power failure detection circuit and an audio processing circuit. Moreover, the present invention can be effectively applied to an electronic device comprising no speakers (for example, a recording/reproducing device such as a DVD player) as long as the electronic device comprises an audio processing circuit.

The electronic device comprises the audio mute control circuit according to claim 1. With this configuration, the power fail signal outputted from the power failure detection circuit capable of detecting the suspension of power supply from the external power supply ("power supply shutdown" not caused by the input of a power switch) is used as the mute control signal of the audio processing circuit. Thus, it is possible to effectively prevent the occurrence of a "click noise" even in "power supply shutdown" not caused by the input of a power switch (for example, when the AC plug of the device is removed or power supply is suspended by turning off the switch of a power strip).

The electronic device comprises the audio mute control circuit of claim 2 according to claim 3 of the present invention. With this configuration, the control of the microcomputer or the like or an element controlled by the microcomputer or the like is not present between "the detection of the suspension of power supply from the external power supply" and "the output of the mute command to the audio mute control circuit." Thus, it is possible to effectively prevent the occurrence of a "click noise" with high responsiveness (because there is no processing time in the microcomputer).

The electronic device comprises the audio mute control circuit of claim 2 according to claim 4. With this configuration, the "audio mute control circuit" can be configured with two transistors. Therefore, it is possible to reduce the space of the circuit and the cost of the device and increase responsiveness because of a smaller number of circuit elements, thereby effectively preventing the occurrence of a "click noise."

## Claims

1. An electronic device comprising an audio mute control circuit (50, 70), the electronic device further comprising: a microcomputer (30) for control of the electronic device, a power supply unit (10) for receiving power supply from an external power supply and supplying the power to the overall electronic device, a power failure detection circuit (20) for detecting presence or absence of power supply from the external power supply to the power supply unit and arranged to output a power fail signal, and an audio processing circuit (80) for processing an audio signal, **characterized in that** the power fail signal outputted from the power failure detection circuit (20) is directly outputted to the mute control circuit (50, 70) and is used as a mute control signal of the audio processing circuit (80).

2. An electronic device of claim 1, wherein said audio mute control circuit is a switching circuit performing a switching operation in response to a mute control signal from the microcomputer and said power fail signal outputted from the power failure detection circuit (20), the audio mute control circuit (50, 70) being arranged to output a mute command to the audio processing circuit (80) when the power fail signal indicates the failure of power supply from the external power supply to the power supply unit (10), and the audio mute control circuit (50, 70) being arranged to output a mute control signal to the audio processing circuit (80) according to the state of the mute control signal from the microcomputer when said power fail signal indicates the presence of power supply from the external power supply to the power supply unit (10).

3. An electronic device of claim 2, wherein the audio mute control circuit is configured such that a power fail output terminal (21) provided on the power failure detection circuit (20) to output the power fail signal is connected to a base of a first transistor (71), a constant voltage source (77) is connected to a collector of the first transistor (71), a collector of a second transistor (72) is connected to an emitter of the first transistor (71), a mute control signal output terminal provided on the microcomputer to output the mute control signal (31)is connected to a base of the second transistor (72), an emitter of the second transistor (72) is connected to the ground, the collector of the second transistor (72) and a base of a third transistor (73) are connected to each other, a collector of the third transistor (73) is connected to the constant voltage source (77), and an emitter of the third transistor (77) is connected to the ground, and the mute control signal is outputted from the collector of the third transistor (73) to the audio processing circuit (80).

4. An electronic device of claim 2, wherein the audio mute control circuit (50) is configured such that a power fail output terminal (21) provided on the power failure detection circuit (20) to output the power fail signal is connected to a base of a fourth transistor (51), a constant voltage source (77) is connected to a collector of the fourth transistor (51), an emitter of the fourth transistor (51) is connected to the ground, a collector of a fifth transistor (52) having a base connected to a mute control signal output terminal (81) and the base of the fourth transistor (51) are connected to each other, the mute control signal output terminal (81) being provided on the microcomputer to output the mute control signal, and an emitter of the fifth transistor (52) is connected to the ground, and the mute control signal is outputted from the collector of the fourth transistor (51) to the audio processing circuit (80).

## Patentansprüche

1. Elektronische Vorrichtung, umfassend eine Audiostumm-Steuerschaltung (50, 70), wobei die elektronische Vorrichtung ferner Folgendes umfasst: einen Mikrocomputer (30) zur Steuerung der elektronischen Vorrichtung, eine Spannungsversorgungseinheit (10) zum Empfang der Spannungsversorgung von einer externen Spannungsversorgung und zum Versorgen der gesamten elektronischen Vorrichtung mit Spannung, eine Spannungsausfall-Detektionsschaltung (20) zum Detektieren des Vorhandenseins oder Fehlens einer Spannungsversorgung von der externen Spannungsversorgung für die Spannungsversorgungseinheit und die ausgebildet ist, um ein Spannungsausfallsignal auszugeben und eine Audioverarbeitungsschaltung (80) zur Verarbeitung eines Audiosignals, **dadurch gekennzeichnet, dass** das von der Spannungsausfall-Detektionsschaltung (20) ausgegebene Spannungsausfallsignal direkt an die Stumm-Steuerschaltung (50,70) ausgegeben wird und als Stummsteuersignal der Audioverarbeitungsschaltung (80) verwendet wird.

2. Elektronische Vorrichtung nach Anspruch 1, worin die Audiostumm-Steuerschaltung ein Schaltkreis zur Durchführung eines Schaltvorgangs als Antwort auf ein Stummsteuersignal vom Mikrocomputer und auf das von der Steuerausfall-Detektionsschaltung (20) ausgegebene Spannungsausfallsignal ist, wobei die Audiostumm-Steuerschaltung (50, 70) zur Ausgabe eines Stummbefehls an die Audioverarbeitungsvorrichtung (80) ausgebildet ist, wenn das Spannungsausfallsignal den Ausfall der Spannungsversorgung von der externen Spannungsversorgung zur Spannungsversorgungseinheit (10) anzeigt, und die Audiostumm-Steuerschaltung (50, 70) zur Ausgabe eines Stummsteuersignals an die Audioverarbeitungsvorrichtung (80) in Übereinstimmung mit dem Zustand des Stummsteuersignals vom Mikrocomputer ausgebildet ist, wenn das Spannungsausfallsignal das Vorhandensein der Spannungsversorgung von der externen Spannungsversorgung für die Spannungsversorgungseinheit (10) anzeigt.

3. Elektronische Vorrichtung nach Anspruch 2, worin die Audiostumm-Steuerschaltung so ausgebildet ist, dass ein Spannungsausfall-Ausgangsanschluss (21), der auf der Spannungsausfall-Detektionsschaltung bereitgestellt ist, um das Spannungsausfallsignal auszugeben, mit einer Basis eines ersten Transistors (71) verbunden ist, eine Konstantspannungsquelle (77) mit einem Kollektor des ersten Transistors (71) verbunden ist, ein Kollektor eines zweiten Transistors (72) mit einem Emitter des ersten Transistors (71) verbunden ist, ein Stummsteuersignal-Ausgangsanschluss, der auf dem Mikrocomputer zur Ausgabe des Stummsteuersignals (31) bereitgestellt ist, mit einer Basis des zweiten Transistors (72) verbunden ist, ein Emitter des zweiten Transistors (72) mit Masse verbunden ist, der Kollektor des zweiten Transistors (72) und eine Basis des dritten Transistors (73) miteinander verbunden sind, ein Kollektor des dritten Transistors (73) mit der Konstantspannungsquelle (77) verbunden ist und ein Emitter des dritten Transistors (73) mit Masse verbunden ist und das Stummsteuersignal vom Kollektor des dritten Transistors (73) an die Audioverarbeitungsschaltung (80) ausgegeben wird.

4. Elektronische Vorrichtung nach Anspruch 2, worin die Audiostumm-Steuerschaltung (50) so ausgebildet ist, dass ein Spannungsausfall-Ausgangsanschluss (21), der an der Spannungsausfall-Detektionsschaltung (20) bereitgestellt ist, um das Spannungsausfallsignal auszugeben, mit einer Basis eines vierten Transistors (51) verbunden ist, eine Konstantspannungsquelle (77) mit einem Kollektor des vierten Transistors (51) verbunden ist, ein Emitter des vierten Transistors (51) mit Masse verbunden ist, ein Kollektor eines fünften Transistors (52) mit einer Basis, die mit einem Stummsteuer-Signalausgangsanschluss (81) verbunden ist, und die Basis des vierten Transistors (51) miteinander verbunden sind, wobei der Stummsteuer-Signalausgangsanschluss (81) an dem Mikrocomputer zur Ausgabe des Stummsteuersignals bereitgestellt ist, und ein Emitter des fünften Transistors (52) mit Masse verbunden ist und das Stummsteuersignal vom Kollektor des vierten Transistors (51) an die Audioverarbeitungsschaltung (80) ausgegeben wird.

## Revendications

1. Dispositif électronique comprenant un circuit de contrôle de sourdine (50, 70), le dispositif électronique comprenant par ailleurs: un microprocesseur (30) pour commander le dispositif électronique, un bloc d'alimentation électrique (10) pour recevoir un courant électrique en provenance d'une source d'alimentation électrique externe et pour fournir le courant électrique au dispositif électronique dans son ensemble, un circuit de détection de défaut d'alimentation électrique (20) pour détecter une présence ou une absence de courant électrique de la source d'alimentation électrique externe vers le bloc d'alimentation électrique, et arrangé pour délivrer en sortie un signal de défaut d'alimentation électrique, et un circuit de traitement audio (80) pour traiter un signal audio, **caractérisé en ce que** le signal de défaut d'alimentation électrique délivré en sortie par le circuit de détection de défaut d'alimentation électrique (20) est directement envoyé vers le circuit de contrôle de sourdine (50, 70) et est utilisé en tant qu'un signal de commande de sourdine du circuit de traitement audio (80).

2. Dispositif électronique selon la revendication 1, dans lequel ledit circuit de contrôle de sourdine est un circuit dé commutation qui accomplit une opération de commutation en réponse à un signal de commande de sourdine envoyé par le microprocesseur et audit signal de défaut d'alimentation électrique délivré en sortie par le circuit de détection de défaut d'alimentation électrique (20), le circuit de contrôle de sourdine (50, 70) étant arrangé pour délivrer en sortie une commande de sourdine vers le circuit de traitement audio (80) quand le signal de défaut d'alimentation électrique indique le défaut d'alimentation électrique de la source d'alimentation électrique externe vers le bloc d'alimentation électrique (10), et le circuit de contrôle de sourdine (50, 70) étant arrangé pour délivrer en sortie un signal de commande de sourdine vers le circuit de traitement audio (80) en accord avec l'état du signal de commande de sourdine délivré en sortie par le microprocesseur quand ledit signal de défaut d'alimentation électrique indique la présence d'une alimentation électrique de la source d'alimentation électrique externe vers le bloc d'alimentation électrique (10).

3. Dispositif électronique selon la revendication 2, dans lequel le circuit de contrôle de sourdine est configuré de telle sorte qu'une borne de sortie de signal de défaut d'alimentation électrique (21) prévue sur le circuit de détection de défaut d'alimentation électrique (20) pour délivrer en sortie le signal de défaut d'alimentation électrique est reliée à une base d'un premier transistor (71), une source de tension constante (77) est reliée à un collecteur du premier transistor (71), un collecteur d'un deuxième transistor (72) est relié à un émetteur du premier transistor (71), une borne de sortie de signal de commande de sourdine prévue sur le microprocesseur pour délivrer en sortie le signal de commande de sourdine (31) est reliée à une base du deuxième transistor (72), un émetteur du deuxième transistor (72) est relié à la masse, le collecteur du deuxième transistor (72) et une base d'un troisième transistor (73) sont reliés l'un à l'autre, un collecteur du troisième transistor (73) est relié à la source de tension constante (77), et un émetteur du troisième transistor (77) est relié à la masse, et le signal de commande de sourdine est délivré en sortie depuis le collecteur du troisième transistor (73) vers le circuit de traitement audio (80).

4. Dispositif électronique selon la revendication 2, dans lequel le circuit de contrôle de sourdine (50) est configuré de telle sorte qu'une borne de sortie de signal de défaut d'alimentation électrique (21) prévue sur le circuit de détection de défaut d'alimentation électrique (20) pour délivrer en sortie le signal de défaut d'alimentation électrique est reliée à une base d'un quatrième transistor (51), une source de tension constante (77) est reliée à un collecteur du quatrième transistor (51), un émetteur du quatrième transistor (51) est relié à la masse, un collecteur d'un cinquième transistor (52) ayant une base qui est connectée à une borne de sortie de signal de commande de sourdine (81) et la base du quatrième transistor (51) sont reliés l'un à l'autre, la borne de sortie de signal de commande de sourdine (81) étant prévue sur le microprocesseur pour délivrer en sortie le signal de commande de sourdine, et un émetteur du cinquième transistor (52) est relié à la masse, et le signal de commande de sourdine est délivré en sortie depuis le collecteur du quatrième transistor (51) vers le circuit de traitement audio (80).
